# EUROPEAN PATENT APPLICATION

(11) **EP 4 791 122 A1**
(43) Date of publication of application: **12.08.2026**
(21) Application number: 25226134.2
(22) Date of filing: 22.12.2025
(51) Int. Cl.: H05K 1/11, H05K 1/181, H05K 3/341

(54) **METHODS AND APPARATUS TO ENABLE ATTACHMENT OF SURFACE MOUNT TECHNOLOGY (SMT) COMPONENTS OF DIFFERENT SIZES TO AN UNDERLYING SUBSTRATE**

(30) Priority: 08.02.2025 WO PCT/CN2025/076415; 25.03.2025 US 202563777008 P; 25.09.2025 US 202519340295
(71) Applicant: INTEL Corporation, Santa Clara, CA 95054 (US)
(72) Inventor: MING-SHENG, Tsai, Taipei (TW); KU, Jeff, Taipei (TW); LIM, Min Suet, Gelugor (MY); YU, Haifeng, Shanghai (CN); GO, Jia Yan, Kulim (MY); CHNG, Howlit, Portland (US); SEE, Chun Kit, Bayan Lepas (MY); KAPILA, Smit, Bangalore (IN); ALVA, Samarth, Bangalore (IN)
(74) Representative: Rummler, Felix

(57) **Abstract**

Systems, apparatus, articles of manufacture, and methods to enable attachment of surface mounting technology (SMT) components of different sizes to an underlying substrate are disclosed. An example apparatus includes a circuit board; a first pad on the circuit board, the first pad to be electrically coupled to a first terminal of a surface mounting technology (SMT) component, the first pad having a first edge and a second edge opposite the first edge, the first edge shorter than the second edge; and a second pad on the circuit board, the second pad to be electrically coupled to a second terminal of the SMT component, the second pad having a third edge and a fourth edge opposite the third edge, the third edge shorter than the fourth edge.

## Description

### RELATED APPLICATIONS

This patent claims the benefit of U.S. Provisional Patent Application No. 63/777,008, which was filed on March 25, 2025. This patent also claims the benefit of International Patent Application No. PCT/CN2025/076415, which was filed on February 8, 2025. U.S. Provisional Patent Application No. 63/777,008 and International Patent Application No. PCT/CN2025/076415 are hereby incorporated herein by reference in their entireties. Priority to U.S. Provisional Patent Application No. 63/777,008 and International Patent Application No. PCT/CN2025/076415 is hereby claimed.

### BACKGROUND

Multilayer ceramic capacitors (MLCCs) are components used in many electronic devices. Due to the piezoelectric effect, MLCCs expand and contract in response to voltage changes. Such expansion and contraction can result in vibrations being transmitted to an underlying substrate, such as a printed circuit board (PCB). The extent of the vibrations can vary depending on the size of the MLCCs involved.

### BRIEF DESCRIPTION OF THE DRAWINGS

FIG. 1 is an isometric view of two capacitors (e.g., two MLCCs) of different sizes mounted on different pairs of example capacitor pads.
FIG. 2 illustrates different example pairs of capacitor pads constructed in accordance with teachings disclosed herein that may be employed to implement the pairs of capacitor pads of FIG. 1.
FIG. 3 illustrates an example pair of capacitor pads with regions covered by a solder material to facilitate the attachment of the smaller capacitor shown in FIG. 1.
FIG. 4 illustrates the same example pair of capacitor pads of FIG. 3 but with different regions covered by a solder material to facilitate the attachment of the larger capacitor shown in FIG. 1.
FIG. 5 is an isometric view of the two capacitors of FIG. 1 mounted on different pairs of capacitor pads in accordance with teachings disclosed herein.
FIG. 6 shows cross-sectional views of different capacitors on different PCBs to illustrate the benefit of including the capacitor expander of FIG. 5.
FIG. 7 illustrates three example capacitor assemblies that include a smaller capacitor and an expander to result in a size comparable to a larger capacitor.
FIG. 8 is an isometric top view of an example assembly that may be used to implement the third capacitor assembly of FIG. 7.
FIG. 9 is an isometric cutaway view of the example assembly of FIG. 8 cut along the line 9-9 shown in FIG. 8.
FIG. 10 is an isometric bottom view of the example assembly of FIG. 8.
FIG. 11 is an exploded view of the example assembly of FIG. 8.
FIG. 12 is an isometric top view of another example assembly that may be used to implement the third capacitor assembly of FIG. 7.
FIG. 13 is an isometric cutaway view of the example assembly of FIG. 12 cut along the line 13-13 shown in FIG. 12.
FIG. 14 is an isometric bottom view of the example assembly of FIG. 12.
FIG. 15 is an exploded view of the example assembly of FIG. 12.
FIGS. 16-18 illustrates different stages in an example method to attach (e.g., surface mount) any of the example assemblies of FIGS. 7-15 containing a smaller capacitor onto a PCB with capacitor pads dimensioned for a larger capacitor.
FIGS. 19-23 illustrate different stages in another example method to attach (e.g., surface mount) the first capacitor assembly of FIG. 7.
FIG. 24 is a top view of an example PCB assembly with an array of large capacitors.
FIG. 25 illustrates an example PCB assembly similar to that shown in FIG. 24 except that individual rows of the large capacitors of FIG. 24 have been replaced with corresponding rows of smaller capacitors.
FIG. 26 illustrates an example PCB assembly similar to that shown in FIG. 25 except that the larger and smaller capacitors are arranged in a checkerboard pattern.
FIG. 27 is a flowchart representative of an example method of manufacturing any one of the example PCB assemblies of FIGS. 24-26 using any of the example capacitor pads of FIGS. 1-23 and/or any of the example capacitor expanders of FIGS. 5-23.
FIG. 28 is a block diagram of an example electrical device constructed in accordance with teachings disclosed herein

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

There is demand for computing devices with increased capacity. A large driver of this demand is the workloads associated with the advancing field of artificial intelligence (AI). One way to meet the high computational demands of modern computing (whether for AI or other applications) is to implement computing systems with a large number of central processing units (CPUs) and/or CPU cores, a large number of graphics processing units (GPUs) and/or GPU cores, a large number of neural processing units (NPUs) and/or NPU tiles, and/or a large number of field programmable gate arrays (FPGAs). However, to increase the computational capacity of a system in this manner requires an increase in power. Supplying the needed higher power to such systems (e.g., systems with many cores/tiles) requires more power rails and more capacitors than was needed in the past. The inclusion of more capacitors poses a challenge to meet target acoustic design specifications because capacitors (e.g., multilayer ceramic capacitors (MLCCs)) produce vibrations that can result in audible noise. More particularly, MLCCs create vibrations as they expand and contract in response to electric field changes (e.g., the piezoelectric effect) that can cause vibrations in the underlying printed circuit board (PCB) to which the MLCCs are attached. When the resulting vibrations of the PCB are within the frequency band of the audible range (e.g., 20Hz to 20kHz), the vibrations are recognized as an audible noise that may be characterized as a buzzing or singing that may be annoying and/or uncomfortable for humans to hear.

While it is theoretically possible to design PCBs and the associated placement of MLCCs thereon to reduce (e.g., minimize) the amount of acoustic noise that will result, this is difficult to do in practice because acoustic noise is difficult to simulate or model before a fully closed system assembly has been developed. However, developing a fully closed system assembly only to then discover it produces an unacceptable amount of acoustic noise is cost prohibitive.

Another possible solution to reduce acoustic noise is to place matching capacitors on either side of the PCB in an attempt to have the impact of the piezoelectric effect of each capacitor on the PCB (e.g., the vibrations) cancel out (or at least dampen) the vibration effects of the other capacitor. However, this approach is not that effective and requires complicated layout designs. Moreover, placing capacitors on both sides of a PCB is often not viable in space constrained applications because of the significant increase in Z-height. Another solution is to make capacitors taller and/or farther away from the PCB to reduce the transfer of vibrations to the underlying PCB. However, this approach also adds to the overall Z-height and, thus, is often not acceptable. Another potential solution is to add slots through the PCB adjacent a capacitor to mechanically isolate (at least partially) the portion of the PCB supporting the capacitor from the surrounding portion(s) of the PCB. However, such an approach results in complicated layout designs (e.g., uses up real estate within the PCB for electrical interconnects) and negative electrical effects (e.g., the power plane is degraded due to voids from the slots extending through the PCB).

Another approach to reduce acoustic noise caused by the vibration of capacitors is to replace larger capacitors on a PCB with smaller capacitors. Larger capacitors produce larger PCB vibrations (e.g., vibrate the PCB at higher magnitude) and, thus, higher acoustic noise. As such, replacing larger capacitors with smaller ones will reduce the magnitude of the vibrations and, thus, reduce the level of acoustic noise. However, this solution is not a simple matter of swapping out one size for another because each size of capacitor is typically attached to a PCB via a pair of contacts (e.g., pads) on the PCB that are dimensioned according to the size of the capacitor. That is, the footprint of capacitor pads for a larger capacitor are larger than the footprint of capacitor pads for a smaller capacitor. The reason capacitor pads are designed with different footprints for different sized capacitors is to avoid a number of issues that can otherwise result. For instance, attempting to mount a smaller capacitor on oversized capacitor pads can result in the capacitor shifting out of position (e.g., skewing) during the solder reflow process, which may lead to a short circuit. Additionally or alternatively, attempting to mount a capacitor on the wrong size of capacitor pads can results in the capacitor tilting and/or flipping up onto an edge (sometimes referred to as a tombstone failure). Furthermore, irregular filleting of the solder along a capacitor terminal that is misaligned, skewed, tilted, and/or flipped on edge can result in cracks in the solder that can undermine the reliability of the electrical connection. In summary, different sizes of capacitors are not interchangeable on existing PCBs because the capacitor pads are designed for a particular size of capacitor. As such, using smaller capacitors to reduce noise requires a complete redesign and fabrication of a different PCB with smaller capacitor pads, which can be cost prohibitive.

Examples disclosed herein overcome the above concerns through the implementation of capacitor pads shaped for mounting capacitors of different sizes without the need for redesigning and/or fabricating a new PCB. Example capacitor pads disclosed herein have the advantage of enabling capacitors of different sizes to be interchanged or swapped out on the same capacitor pads of the same PCB (and/or positioned in different arrangements of small and large capacitors on two similarly designed PCBs). Other examples disclosed herein advantageously overcome the above concerns through the use of a capacitor expander to increase the effective size of a smaller capacitor so it can more reliably by mounted on capacitor pads designed for a larger capacitor. In some examples, a capacitor expander, as disclosed herein, is used in combination with the capacitor pads disclosed herein. However, in other examples, either one of the disclosed capacitor pads or the capacitor expander are used individually without the other.

Although examples are described with reference to capacitors, teachings disclosed herein can similarly be applied to any type of electrical components (e.g., resistors) that come in different sizes and are surface mounted to a PCB (e.g., a surface mounting technology (SMT) component). That is, in some examples, the contact pads for any type of SMT components can be modified in accordance with teachings disclosed herein to enable different sizes of the components to be attached to the same footprint of contact pads. Additionally or alternatively, expanders can be attached to smaller SMT components of any suitable type to enable such components to be surface mounted to contact pads designed for a larger SMT component of the same type in accordance with teachings disclosed herein.

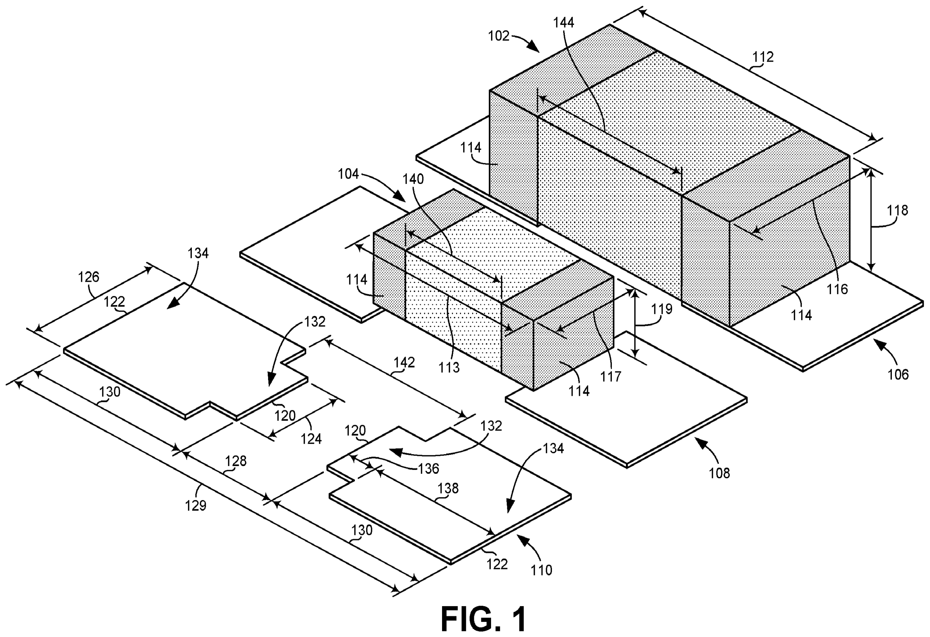

FIG. 1 is an isometric view of two capacitors 102, 104 (e.g., two MLCCs, two SMT components) of different sizes. As shown, the capacitors 102, 104 are mounted on different pairs of example capacitor pads 106, 108, 110 (e.g., contacts). In this examples, the capacitor pads 106, 108, 110 are constructed in accordance with teachings disclosed herein. In some examples, the capacitor pads 106, 108, 110 are distributed along an exterior surface of a PCB (e.g., means for supporting electronic components). Thus, the capacitor pads 106, 108, 110 are example means for mounting electronic components to a PCB. However, the PCB is omitted in FIG. 1 for the sake of clarity. In this example, the first capacitor 102 is positioned on the first pair of capacitor pads 106, the second capacitor 104 is positioned on the second pair of capacitor pads 108, and the third pair of capacitor pads 110 do not have a capacitor disposed thereon to show a shape of the example capacitor pads 106, 108, 110. In this example, the footprint of each pair of capacitor pads 106, 108, 110 is the same. That is, the first and second pair of capacitor pads 106, 108 have the same size and same shape as the third pair of capacitor pads 110.

As shown in the illustrated example, the first capacitor 102 is larger than the second capacitor 104. More particularly, in this example, the first capacitor 102 has a first length 112 that is greater than a second length 113 of the second capacitor 104, where the lengths 112, 113 are measured in a direction extending between the terminals 114 at either end of the capacitors 102, 104. Further, the first capacitor 102 has a first width 116 that is greater than a second width 117 of the second capacitor 104, where the widths 116, 117 are measured in a direction extending transverse to the respective lengths 112, 113 and parallel to the exposed upper surface of the capacitor pads 106, 108, 110. Further still, in this example, the first capacitor 102 has a first height 118 (e.g., thickness) that is greater than a second height 119 (e.g., thickness) of the second capacitor 104, where the heights 118, 119 are measured in a direction perpendicular to the exposed upper surfaces of the capacitor pads 106, 108, 110 (e.g., perpendicular to the lengths 112, 113 and widths 116, 117 of the capacitors 102, 104). Notably, the lengths 112, 113 and the widths 116, 117 of the capacitors 102, 106 are the most relevant for the reliable mounting of the capacitors 102, 104 to the underlying pads 106, 108, 110 because the lengths 112, 113 and the widths 116, 117 define the overall footprints of the capacitors 102, 104.

In this example, the capacitors 102, 104 are attached to the corresponding pairs of capacitor pads 106, 108 via solder. However, for purposes of explanation, the solder is not shown. In some examples, at least some solder is on the underside of the capacitors 102, 104 between the capacitors 102, 104 and the underlying capacitor pads 106, 108. Additionally or alternatively, in some examples, the solder extends along the outer edge of the capacitors 106, 104 where the terminals 114 interface with the capacitor pads 106, 108. In some such examples, the solder defines a fillet that extends along the interface between the terminals 114 and the exposed portion(s) of the corresponding capacitor pads 106, 108. In some examples, the solder spreads across (e.g., completely covers) the entire exposed area of the capacitor pads 106, 108, 110. However, in other examples, the solder may remain adjacent to the terminals 114 of the capacitors 102, 104 with at least some of the capacitor pads 106, 108, 110 remaining exposed and/or uncovered by solder.

Due to the shape of the capacitor pads 106, 108, 110, both of the capacitors 102, 104 can reliably be attached thereto despite the difference in size between the capacitors 102. More particularly, as shown in the illustrated example, each pad in a corresponding pair of capacitor pads 106, 108, 110 includes an inner facing edge 120 that is smaller (e.g., shorter) than an opposing outer facing edge 122. That is, the inner facing edge 120 has a third width 124 that is less than a fourth width 126 of the outer facing edge 122. As shown, the inner facing edges 120 face towards one another and define the closest portions of the two pads in each pair of capacitor pads 106, 108, 110 that are spaced a first distance 128 apart. By contrast, the outer facing edges 122 face away from one another and define the portions of the two pads that are spaced the farthest apart at a second distance 129 corresponding to a sum of the first distance 128 and the length 130 of both corresponding capacitor pads 106, 108, 110.

Capacitor pads are often described using terminology associated with foot anatomy. That is, just as the heels of a foot are under the body and the toes of a foot stick out and away from the body, the area of the capacitor pads 106, 108, 110 directly under the capacitors (e.g., defined by and adjacent to the inner facing edge 120) is referred to as the heel 132 of the pads. By contrast, the areas of the capacitor pads 106, 108, 110 that stick out beyond the ends of the capacitor pads 106, 108, 110 (e.g., defined by and adjacent to the outer facing edge 122) is referred to as the toe 134 of the pads. Thus, as shown in the illustrated example, the heels 132 of the corresponding pairs of pads 106, 108, 110 (which face inwards and towards one another) are smaller or narrower than the toes 134 (which face outwards and away from one another). In this example, the heel 132 is associated with a narrower portion (defined by the third width 124) and the toe is associated with a wider portion (defined by the fourth width 126). In this example, the narrower portion has a third length 136 that is less than a fourth length 138 of the wider portion. In other examples, the third length is equal to or greater than the fourth length 138.

As shown in FIG. 1, both of the capacitors 102, 104 extend onto and/or over the heels 132 of the corresponding pairs of capacitor pads 106, 108, 110, while leaving the toes 134 uncovered and/or exposed. This is true despite the difference in size of the capacitors 102, 104. However, the extent that the heels 132 are covered and/or the amount of the toes 134 left uncovered differs between the two capacitors 102, 104. More particularly, in the illustrated example of FIG. 1, the second capacitor 104 is primarily limited to extending over the narrow portion of the heels 132, whereas the first capacitor 102 extends farther to reach the wider portion of the pads (e.g., near a middle of the pads between the toe 134 and the heel 132). Further, in this example, the width of the narrow heels 132 (e.g., the third width 124) is equal to or less than the width 117 of the second (smaller) capacitor 104, whereas the width of the toes 134 (e.g., the fourth width 126) of the capacitor pads 106, 108, 110 is approximately equal to the width 116 of the first (larger) capacitor 102. In some examples, the width of the toes 134 (which corresponds to the maximum width of the capacitor pads in some examples) is less than the width 116 of the first capacitor 102.

The widths 124, 126 of the toes 134 and the heels 132 being equal to or less than the widths 116, 117 of the respective first and second capacitors 102, 104 limits or confines the area underneath the capacitors 102, 104 that solder can spread, thereby preventing the shifting and/or tilting of the capacitors 102, 104 out of their intended place evenly and squarely spanning across the corresponding pair of capacitor pads 106, 108, 110. Although the examples show the widths 124, 126 of the pads 106, 108, 110 being equal to or less than the widths 116, 117 of the capacitors 102, 104, in other examples, the toes 134 and/or the heels 132 can have widths 124, 126 that are at least somewhat larger than the widths 116, 117 of the respective first and second capacitors 102, 104.

In some examples, the different widths 124, 126 of the different portions (e.g., the heel 132 and the toe 134) can help reduce (e.g., prevent) shifting of the capacitors 102, 104 in a directly perpendicular to their lengths 112, 113. Further, in some examples, the size and/or spacing of the different portions of the of the capacitor pads 106, 108, 110 along the longitudinal length 112, 113 of the capacitors 102, 104 help reduce (e.g., prevent) shifting in a direction parallel to the longitudinal length. More particularly, in some examples, the first distance 128 between the heels 132 is equal to or less than a third distance 140 between the terminals 114 of the second capacitor 104. In some examples, the first distance 128 is greater than the third distance 140 but still less than the full length 113 of the second capacitor 104. Defining the first distance 128 between the capacitor pads 106, 108, 110 based on the third distance 140 between the terminals 114 of the second (smaller) capacitor 104 may help constrain the second capacitor 104 centered across the gap between the two pads. Further, in some examples, a fourth distance 142 between the portions of the capacitor pads having the greatest width 126 (e.g., defining the toe 134 of the pads) is equal to or less than a fifth distance 144 between the terminals 114 of the first capacitor 102. In some examples, the fourth distance 142 is greater than the fifth distance 144 but still less than the full length 112 of the first capacitor 102. Defining the fourth distance 142 based on the fifth distance 144 may help constrain the second capacitor 104 centered across the gap between the two pads.

In summary, the shape of the capacitor pads 106, 108, 110 of the illustrated example help maintain the position of both the larger and smaller capacitors 102, 104 during a solder reflow process for reliable attachment to the capacitor pads 106, 108, 110. As a result, either size of capacitor 102, 104 can reliably be mounted to the example capacitor pads 106, 108, 110 shown in FIG. 1.

In some examples, the first (larger) capacitor 102 is an 0603 capacitor and the second (smaller) capacitor 104 is an 0402 capacitor. 0603 capacitors have a length 112 of 0.06 inches and a width 116 of 0.03 inches, whereas 0402 capacitors have a length 112 of 0.04 inches and a width 116 of 0.02 inches. 0603 capacitors and 0402 capacitors are two form factors for MLCCs that are widely used in PCB design and each have different benefits and drawbacks. For instance, 0603 capacitors are relatively cheap and offer capacitances well within range to target a low alternating current (AC) load-line between 100 kilohertz (kHz) to 2 megahertz (MHz). However, 0603 capacitors generate much more acoustic noise (due to much larger vibrations) than 0402 capacitors. Thus, while 0603 capacitors provide desirable electrical properties at an affordable price, these advantages may be offset by the significant noise that results from their use, particularly when a large number of such capacitors are used in combination. In other words, there is a trade-off between effective, low-cost capacitors on the one hand and low noise capacitors on the other hand. A balance can be struck between these two trade-offs by using some 0603 capacitors (to save costs and enhance performance) and some 0402 capacitors (to reduce noise levels).

In the past, any change in the number of each type of capacitor on an underlying PCB based on changes in the desired balance between the two trade-offs noted above required a complete redesign and reconstruction of a new PCB. A completely new PCB was needed in the past in such situations because different sizes of capacitor pads were used for each of the different sizes of capacitors. Unlike what has been done in the past, there is no need to redesign and/or rebuild a PCB that includes the pairs of capacitor pads 106, 108, 110 shown in FIG. 1 to replace a larger 0603 capacitor (e.g., the first capacitor 102) with a smaller 0402 capacitor (e.g., the second capacitor 104) or vice versa. On the contrary, in accordance with teachings disclosed herein, the very same PCB design can advantageously be used because each pair of capacitor pads 106, 108, 110 can support (e.g., is compatible with) either size of capacitor. That is, the capacitors 102, 104 are completely interchangeable or swappable on any given one of the pairs of capacitor pads 106, 108, 110. To be clear, while the capacitor pads 106, 108, 110 are described as being compatible with both large and small capacitors 102, 104 such that the capacitors can be swapped out, examples are not limited to situations where one capacitor is interchanged with another capacitor on the very same board. Rather, in some examples, a first arrangement of capacitors can be implemented on a first PCB and a second arrangement of capacitors (with at least some being a different size than in the first arrangement) can be implemented on a second PCB having the same design (e.g., same layout of capacitor pads) as the first PCB. Although the capacitors 102, 104 in the illustrated example of FIG. 1 have been described as corresponding to 0603 and 0402 capacitors, examples disclosed herein are not limited to any particular sizes of capacitors. Rather, teachings disclosed herein can apply to any suitable sizes of capacitors (e.g., 0805 capacitors, 1206 capacitors, etc.).

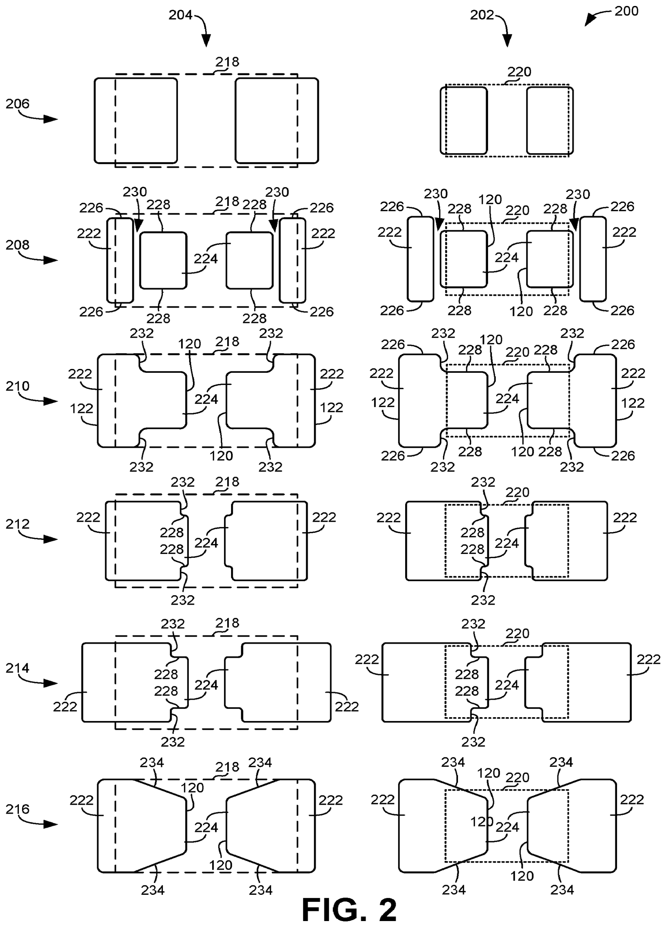

FIG. 2 illustrates different example pairs of capacitor pads 200 (e.g., contacts, means for mounting electronic components on a PCB) that may be employed to implement the pairs of capacitor pads 106, 108, 110 of FIG. 1 to enable different sized capacitors (e.g., the first and second capacitors 102, 104) to be interchangeably mounted thereto. More particularly, FIG. 2 includes two columns (e.g., a first column 202 and a second column 204) and six rows (e.g., a first row 206, a second row 208, a third row 210, a fourth row 212, a fifth row 214, and a sixth row 216) of corresponding pairs of the example capacitor pads 200. Each pair of the capacitor pads 200 in the first column 202 is overlaid by a relatively large dashed box 218 corresponding to the footprint of a larger capacitor (e.g., a 0603 capacitor, the first capacitor 102 of FIG. 1). For purposes of explanation, the dashed box 218 representing the footprint of the larger capacitor is sometimes simply referred to as the larger capacitor 218. Further, each pair of the capacitor pads 200 in the second column 204 is overlaid by a smaller dashed box 220 corresponding to the footprint of a smaller capacitor (e.g., a 0402 capacitor, the second capacitor 104 of FIG. 1). For purposes of explanation, the dashed box 220 representing the smaller capacitor is sometimes simply referred to as the smaller capacitor 220. As shown in the illustrated example, with the exception of the first row 206, the pairs of capacitor pads 200 in each of the second through sixth row 208, 210, 212, 214, 216 are identical across both columns 202, 204. That is, the only thing that differs between the first and second columns 202, 204 in these rows 208, 210, 212, 214, 216 is the different sized dashed boxes 218, 220.

As shown in the illustrated example, each pad 200 in any given pair of pads has the same size and shape as the other pad in the corresponding pair. However, in some examples, the corresponding pads in a given pair of pads have an opposite orientation. That is, in some examples, the two pads in a given pair of pads are mirror images of one another along a center line extending between pair of pads. As such, in some examples, the overall footprint of any given pair of pads is symmetrical both longitudinally and laterally. Singificantly, however, in this example, individual ones of the pads 200 in any given pair in the second through sixth rows 208, 210, 212, 214, 216 are not longitudinally symmetrical because of the narrower heel 132 relative to the wider toe 134 as discussed above in connection with FIG. 1.

The pair of capacitor pads 200 in each column 202, 204 of the first row 206 differ from one another because this row 206 is intended to show known designs for capacitor pads that are typically used on PCBs today. That is, the first row 206 in FIG. 2 is provided for purposes of comparison between what has been done in the past and the new designs disclosed herein as shown in the other rows 208, 210, 212, 214, 216. As shown in the first row 206, standard capacitor pads in use today are typically rectangular in shape and dimensioned to have a width equal to or slightly less than the width of the corresponding capacitors to be mounted therein. Thus, unlike what is shown in the other rows 208, 210, 212, 214, 216, the known pads in the first row 206 are individually symmetrical both laterally and longitudinally. Further, a total length of a pair of known capacitor pads 200 is designed to be slightly longer than the length of each corresponding capacitor to be mounted thereon. While the designs of the known capacitor pads 200 shown in the first row of FIG. 2 are suitable to attach a capacitor of the corresponding size, they would not be suitable to attach the other sized capacitor. More particularly, attempting to attach the larger capacitor 218 to the pair of pads 200 in the second column 204 and/or attempting to attach the smaller capacitor 220 to the pair of pads 200 in the first column 202 is likely to result in shifting, tilting, tombstoning, solder cracking, and/or other unreliable connections between the capacitors and the underlying pads.

Unlike known capacitor pads (represented in the first row 206 of FIG. 2), the capacitor pads 200 shown in the second through sixth rows 208, 210, 212, 214, 216 of FIG. 2 facilitate reliable connections of both the larger and smaller capacitors 218, 220. As shown in the illustrated example, each capacitor pad 200 in the pairs of pads in the second row includes two portions (e.g., a first portion 222 and a second portion 224). In some examples, the first portions 222 of the pair of pads 200 are dimensioned and positioned to enable attachment of the larger capacitor 218. Thus, the first portions 222 are examples of first means for attaching a first component (e.g., the larger capacitor 218) of a first size. Further, the second portions 224 are dimensioned and positioned to enable attachment of the smaller capacitor 220. Thus, the second portions 224 are examples of second means for attaching a second component (e.g., the smaller capacitor 220) of a second size that is smaller than the first size. In this example, the portions 222, 224 of both pads 200 in a corresponding pair are all arranged in a line (extending horizontally across the page in FIG. 2) with the second portions 224 closer together and between the first portions 222.

In the second row 208 of the illustrated example, the two portions 222, 224 are discrete and separate from (e.g., spaced apart from) one another. As shown, the first portion 222 has a first width (defined by the distance between by first side edges 226 (e.g., the fourth width 126 of FIG. 1)) that is wider than a second width of the second portion 224 (defined by the distance between substantially parallel second side edges 228 (e.g., the third width 124 of FIG. 1)). As used in this context, width is measured in the same direction as described above for FIG. 1, which corresponds to a direction extending vertically along the page in FIG. 2 (e.g., extending perpendicular to a line along which the different portions 222, 224 of the corresponding pairs of pads 200 are arranged). In the second row 206 of FIG. 2, the first portion 222 has a width that is wider than the width of the smaller capacitor 220, whereas the second portion 224 is less than the width of the smaller capacitor 220. Further, in this example, the first portion 222 is less than the width of the larger capacitor 218. In some examples, the first portion 222 has a width equal to the larger capacitor 218 and/or the second portion 224 has a width equal to the smaller capacitor 220. As used herein, substantially parallel means within 10 degrees of exactly parallel. Further, as used herein, substantially perpendicular means within 10 degrees of exactly perpendicular.

In the example shown in the second row 208 of FIG. 2, the first portion 222 of each pad has a shorter length (e.g., measured in a direction extending horizontally across the page) that is less than second portion 224 (e.g., the length 136 compared to the length 138 in FIG. 1). In other examples, the lengths of both portions 222, 224 are equal. In other examples, the length of the first portion 222 is greater than the length of the second portion 224. Regardless of the relative lengths of the portions 222, 224, as shown in the illustrated example, the lengths (and associated spacing of the portions), are such that the first portions 222 extend beyond the ends of the larger capacitor 218 and the second portions 224 extend beyond the ends of the smaller capacitor 220.

As noted above, in the illustrated example of FIG. 2, the two portions 222, 224 of the example pads 200 in the second row 208 are discrete and spaced apart from one another with a gap 230 therebetween. In other examples, at least some metal bridges this gap 230. In some examples, the gap is bridged by one or more strips of metal that are narrower than the first portion 224. That is, in some examples, there is a narrow neck of metal connecting the two portions 222, 224. In some examples, the gap 230 between the first and second portions 222, 224 is completely filled with metal such that the second portion 224 is a continuous extension (e.g., an integral extension) of the first portion 222. This substantially corresponds to the example capacitor pads 200 shown in the third row 210 of FIG. 2. However, the capacitor pads 200 in the third row 210 also differ from the second row 208 in that the first portions 222 are longer (e.g., they extend out farther away from the ends of the larger capacitor 218) and wider (e.g., they equal the width of the larger capacitor 218).

As shown in the third row 210 of FIG. 2, there are inward facing recessed edges 232 (e.g., inner edges of the first portions 222) that extend between the first side edges 226 of the first portions 222 and the second side edges 228 of the second portions 224. In other words, the first and second side edges 226, 228 with the recessed edges 232 extending therebetween define a stepped profile along the side edges of the pads 200. That is, in some examples, the inward facing recessed edges 232 and the first and second side edges 226, 228 collectively correspond to different segments of a complete side edge of the pads that extend from the inner facing edges 120 to the outer facing edges 122 that follows a non-linear line. In the third row 210 of FIG. 2, the length of the second side edges 228 are relatively long such that the recessed edges 232 are located beyond the ends of the smaller capacitor 220 (but still within the ends of the larger capacitor 218). In other examples, as shown in the fourth row 212 in FIG. 2, the length of the second side edges 228 are relatively short such that the recessed edges 232 are located well within the ends of the smaller capacitor 220. In other examples, the length of the second side edges 228 and the corresponding location of the recessed edges 232 can be at any other suitable location. In some examples, the location of the recessed edges 232 are aligned with the ends of the smaller capacitor 220. Thus, in some examples, the side edges 226 are longer than the recessed edges 232 (as in the examples shown in the third row 210 in FIG. 2). In other examples, the side edges 226 are shorter than the recessed edges 232 (as in the examples shown in the fourth row 212 in FIG. 2). In other examples, the side edges 226 are approximately the same in length as the recessed edges 232 (as in the examples shown in the fifth row 214 in FIG. 2).

Aside from the slightly different shape of the stepped profile, the example pads 200 in the fifth row 214 differ from the previous examples in that the overall lengths of the pads 200 is greater to extend farther beyond the ends of the larger capacitor 218. That is, the first portions 222 in the fifth row 214 are significantly longer than in any of the other rows 208, 210, 212, 216 shown in FIG. 2.

In the sixth row 216 of FIG. 2, the example capacitor pads 200 do not include a stepped profile based on the different widths of the first and second portions 222, 224. Rather, in the sixth row 216, the second portions 224 of the example capacitor pads 200 are defined by angled side edges 234 (e.g., tapered side edges) that extend directly between the inner facing edges 120 of the capacitor pads 200 and the first side edges 226 of the first portions 222. Inasmuch as the inner and outer facing edges 120, 122 are different lengths, the angled side edges 234 are non-perpendicular relative to the inner and outer facing edges 120, 122. In this example, the outer ends of the angled sides edges 234 are farther apart than the width of the smaller capacitor 220. However, the inner ends of the angled side edges 234 are closer together than the width of the smaller capacitor 220. That is, in this example, only part of the second portion 224 of each pad 200 has a width that is less than or equal to the width of the smaller capacitor 220. In some examples, the angle or steepness of the angled side edge 234 depends on the total length of each pad 200 (e.g., the length 130 in FIG. 1) and the length of the first portion 222 (e.g., the length 138 in FIG. 1).

In some examples, the angled side edges 234 are used in combination with the second sides edges 228 that extend substantially perpendicular to the inner facing edges 120. That is, in some examples, rather than the inner end of the angled side edges 234 beginning at the inner facing edges 120 of the pads 200, the angled side edges 234 are spaced apart from the inner facing edges 120 by a segment of the second side edges 228 extending therebetween. Additionally or alternatively, in some examples, the angled side edges 234 are used in combination with the recessed edges that extend substantially perpendicular to the first side edges 226 of the first portions 222. In some examples, the first side edges 226 are omitted and the angled side edges 234 extend all the way to the ends of the outer facing edges 122 of the pads. In some examples, the angled side edges 234 are replaced by curved edges. Other shapes are possible based on different combinations of the features shown in the different example capacitor pads 200 in the second through sixth rows 208, 210, 212, 214, 216 of FIG. 2. That is, examples disclosed herein are not limited to the specific examples shown in FIG. 2. Rather, it should be understood that the length, width, and/or positioning of the portions 222, 224 can be suitably modified in accordance with teachings disclosed herein. Further, any of the edges can be straight or non-linear (e.g., curved) and oriented perpendicularly to the inner and outer facing edges 120, 122 or at other angles in any suitable arrangement so long as the heel 132 of the pads 200 is sufficiently narrow to permit suitable attachment by a smaller capacitor 220 and that the toe 134 of the pads 200 is wide enough to permit suitable attachment by a larger capacitor.

Additionally, examples disclosed herein are not limited to facilitating only two sizes of capacitors. In some examples, three or more different sizes of capacitors may be interchangeably attached to example capacitor pads disclosed herein. In some such examples, the pads include a stepped profile that includes two or more steps (rather than the single step shown in the third through fifth rows 210, 212, 214 of FIG. 2).

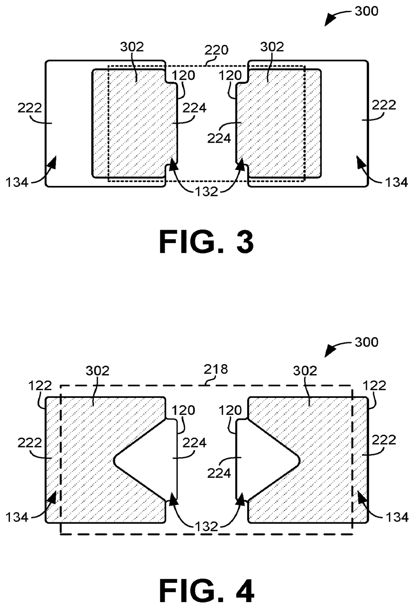

As discussed above, the shapes of the capacitor pads 106, 108, 110, 200 of FIGS. 1 and 2 enable different sized capacitors 102, 104, 218, 220 to be attached to the same pair of capacitor pads. In some examples, the proper positioning and reliable attachment of the different sized capacitors 102, 104, 218, 220 is facilitated by the placement of solder applied to the capacitor pads at the time of attachment. Specifically, FIG. 3 illustrates an example pair of capacitor pads 300 with regions covered by a solder material 302 to facilitate the attachment of the smaller capacitor 220. More particularly, in this example, the solder material 302 (also referred to simply as solder for short) covers an area adjacent the inner facing edge 120 (e.g., adjacent the heels 132) of the capacitor pads 300. In this example, the solder material 302 covers all of the second portions 224 of the capacitor pads 300 but only some of the first portions 222. That is, at least part of the first portion 222 remains uncovered by the solder material 302. In some examples, the solder material 302 is limited exclusively to the second portions 224 of the capacitor pads 300. This may be appropriate when the second portions 224 extend beyond the ends of the smaller capacitors 220 (as in the third row 210 of FIG. 2). In some examples, the solder material 302 covers enough of the capacitor pads 300 (whether covering the first and/or second portions 222, 224) to extend beyond the ends of the smaller capacitor 220. In this example, the solder material 302 is distributed across the capacitor pads 300 a width that is less than the width of the smaller capacitor 220 (and, thus, less than the width of the first portions 222 of the capacitor pads 300). In other examples, the solder material 302 is applied a width approximately equal to or greater than the width of the smaller capacitors 220.

FIG. 4 illustrates the same example pair of capacitor pads 300 of FIG. 3 but with different regions covered by a solder material 302 to facilitate the attachment of the larger capacitor 218. More particularly, in this example, the solder material 302 covers an area adjacent the outward facing edge 122 (e.g., adjacent the toes 134) of the pads 300 while remaining spaced apart from the inner facing edge 120 (e.g., adjacent the heels 132). In this example, the solder material 302 covers only part of the first portion 222 and none of the second portion 224. In other examples, the solder material 302 covers all of the first portion 222 of the pads 300. In some examples, the solder material 302 may cover at least some of the second portion 224.

Controlling placement of the solder material 302 either towards the heel 132 of the capacitor pads 106, 108, 110, 200 (when the smaller capacitor 104 is to be attached) or towards the toe 134 of the capacitor pads 106, 108, 110, 200 (when the larger capacitor 102 is to be attached) reduces the amount of excess solder material 302, thereby reducing the likelihood of capacitor shifting and/or solder balling during the reflow process. At the same time, the placement of the solder material 302 shown in FIGS 3 and 4 helps ensure suitable wettability to the capacitor terminals 114 to ensure reliable electrical connections. In some examples, the placement of the solder material 302 is controlled through the use of a stencil opening and/or other suitable mask.

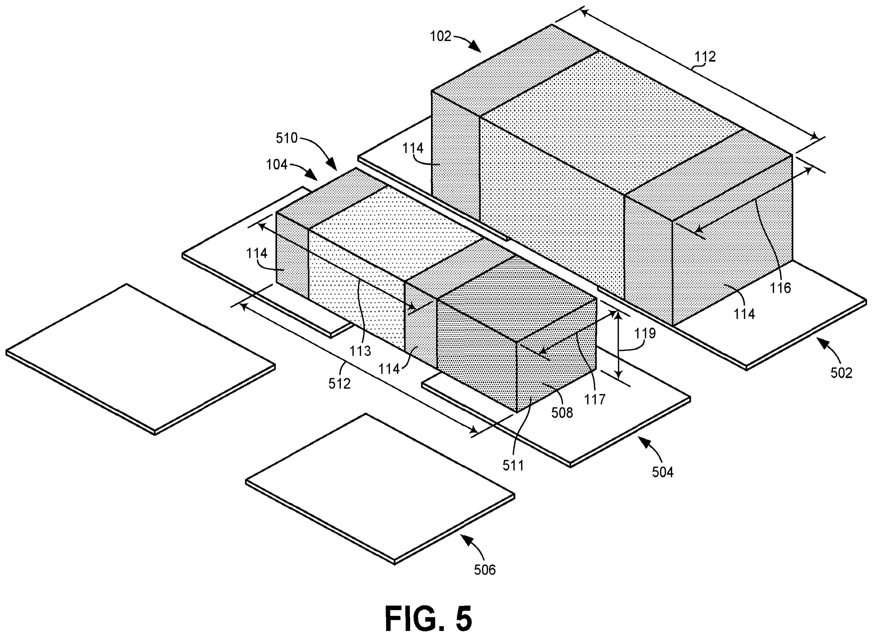

FIG. 5 is an isometric view of the two (large and small) capacitors 102, 104 of FIG. 1 mounted on different pairs of capacitor pads 502, 504, 506 in accordance with teachings disclosed herein. As with FIG. 1, in some examples, the capacitor pads 502, 504, 506 of FIG. 5 are distributed along an exterior surface of a PCB. However, the PCB is omitted in FIG. 5 for the sake of clarity. In this example, the first capacitor 102 is positioned on the first pair of capacitor pads 502, the second capacitor 104 is positioned on the second pair of capacitor pads 504, and the third pair of capacitor pads 506 do not have a capacitor disposed thereon to show a shape of the capacitor pads 502, 504, 506. In this example, the footprint of each pair of capacitor pads 106, 108, 110 is the same. That is, the first and second pair of capacitor pads 106, 108 have the same size and same shape as the third pair of capacitor pads 110. More particularly, in this example, the capacitor pads 502, 504, 506 are generally rectangular and correspond to standard (e.g., known) capacitor pads designed for mounting of the first (larger) capacitor 102. That is, in this example, the capacitor pads 502, 504, 506 are similar to the capacitor pads 200 shown in the first column 202 of the first row 206 of FIG. 2.

Inasmuch as the capacitor pads 502, 504, 506 are standard pads for the first capacitor 102, there is no difficulty in attaching the first capacitor 102 to the pads 502, 504, 506. However, as outlined above, attaching a different size capacitor (such as the smaller second capacitor 104) will create issues that can give rise to the shifting, tilting, tombstoning, and/or other failures in establishing a reliable connection. In this example, these concerns are overcome by including a capacitor expander 508 (also referred to herein as dummy structure, component expander, or capacitor housing) that is coupled to the second capacitor 104 to provide a resulting assembly 510 having a size more suitable mounting to the capacitor pads 502, 504, 506. More particularly, in this example, the capacitor expander 508 is adjacent one end of the second capacitor 104 to increase a total length 512 of the assembly 510 to be approximately the same as the first length 112 of the first capacitor 102. In some examples, the added length of the assembly 510 enables the second capacitor 104 to span the distance between the corresponding pairs of capacitor pads 502, 504, 506 for better attachment. Thus, the capacitor expander 508 is an example means for facilitating an electronic component (e.g., the smaller capacitor 104) to span a distance between an underlying pair of capacitor pads 502, 504, 506.

In this example, the capacitor expander 508 includes an electrically conductive block 511 (e.g., metal block, means for conducting electricity) having a similar width and height as the second capacitor 104. However, the capacitor expander 508 can be any other suitable shape so long as it provided the additional length needed for the assembly and is electrically conductive to ensure the adjacent terminal 114 of the second capacitor 104 is electrically coupled to the corresponding capacitor pad 502, 504, 506. Further, in some examples, the material and the shape of the capacitor expander 508 is selected so as not to contribute to acoustic noise. That is, whereas the reason to use the second capacitor 104 instead of the first capacitor 102 is to reduce acoustic noise, in some examples, the capacitor expander 508 is designed to not exhibit piezoelectric effects that cause vibrations so that the advantages of the lower noise produced by the second capacitor 104 (relative to the first capacitor 102) is retained.

In some examples, the total length 512 of the assembly is achieved with a separate capacitor expander 508 at each end of the second capacitor 104. In some examples, the capacitor expander 508 has a different width and/or a different height than the second capacitor 104. For instance, in some examples, the second capacitor expands laterally beyond the sides of the second capacitor 104 to a width corresponding to the width 116 of the first capacitor 102 to further match the footprint of the first capacitor 102. In some examples, the capacitor expander 508 is positioned along a side of the first capacitor 102 to increase the width of the assembly 510 instead of increasing the length 512. In some examples, the capacitor expander 508 (or multiple capacitor expanders) are attached to at least one side and at least one end of the second capacitor 104. In some examples, the capacitor expander surrounds all sides (e.g., both lateral sides and both ends) of the second capacitor 104 to produce an assembly 510 that approximately corresponds to the footprint of the first capacitor 102.

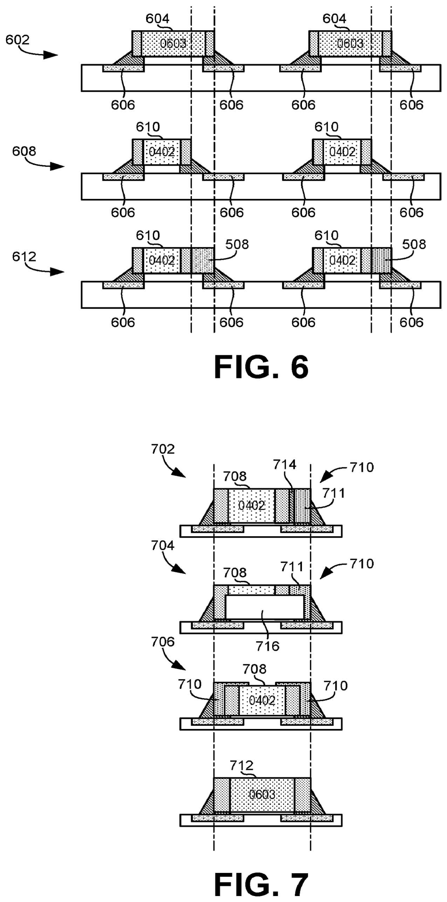

FIG. 6 shows cross-sectional views of different capacitors on different PCBs to illustrate the benefit of including the capacitor expander 508 of FIG. 5. Specifically, the first image 602 shows two 0603 capacitors 604 (corresponding to the first capacitor 102 of FIG. 5) attached to corresponding pairs of 0603 capacitor pads 606. The second image 608 of FIG. 6 shows two 0402 capacitors 610 attached to the 0603 capacitor pads 606. As shown, the smaller 0402 capacitors 610 are not large enough to properly span the distance between the 0603 capacitor pads 606 resulting in an unreliable connection. The third image 612 of FIG. 6 shows the same two 0402 capacitors 610 attached to the same 0603 capacitor pads 606, except the 0602 capacitors 610 include the capacitor expander 508 of FIG. 5. Thus, as shown in FIG. 6, the 0402 capacitors 610 and the capacitor expanders 508 collectively equal the length of the 0603 capacitors 604 to enable a proper connection with the 0603 capacitor pads 606.

There are many different ways in which a capacitor expander (e.g., the capacitor expander 508) can be attached to a smaller capacitor to provide a resulting assembly with dimension(s) larger than the smaller capacitor. Specifically, FIG. 7 illustrates three example capacitor assemblies 702, 704, 706 that include a smaller capacitor 708 and an expander 710 (e.g., means for facilitating the smaller capacitor 708 to span a distance between the pair of underlying capacitor pads) to result in a size comparable to a larger capacitor 712. As shown in the illustrated example, the first assembly 702 is created by affixing a metal block 711 (e.g., means for conducting) the expander 710 to the smaller capacitor 708 with a solder material 714 and/or other electrically conductive adhesive (e.g., means for holding the metal block 711 in position relative to the smaller capacitor 708). Additionally or alternatively, in some examples, the expander 710 is affixed to the smaller capacitor 708 through a transient liquid phase sintering process.

The second assembly 704 in FIG. 7 is created by placing the metal block 711 in direct contact with (e.g., abutting) the smaller capacitor 708 and then holding the components in place by a plate 716 (e.g., means for holding the metal block 711 in position relative to the smaller capacitor 708) affixed to exterior surfaces of both components. In this example, the plate 716 is attached to the lateral sides of the smaller capacitor 708 and the metal block 711. In some examples, separate plates 716 are attached to both lateral sides of the small capacitor 708 and the metal block 711. In some examples, a plate 716 is additionally or alternatively attached to the top surfaces of the small capacitor 708 and the metal block 711. Inasmuch as the expander 710 is in direct contact with the small capacitor 708, the plate 716 does not need to be electrically conductive. Accordingly, in some examples, the plate 716 is plastic. In other examples, the plate can be any other suitable material. In some examples, the plate 716 is attached to the smaller capacitor 708 and the metal block 711 with an adhesive. Additionally or alternatively, in some examples, the plate 716 is part of a clip that include spring forces to clamp on to the smaller capacitor 708 and the metal block 711 via friction without the need for an adhesive.

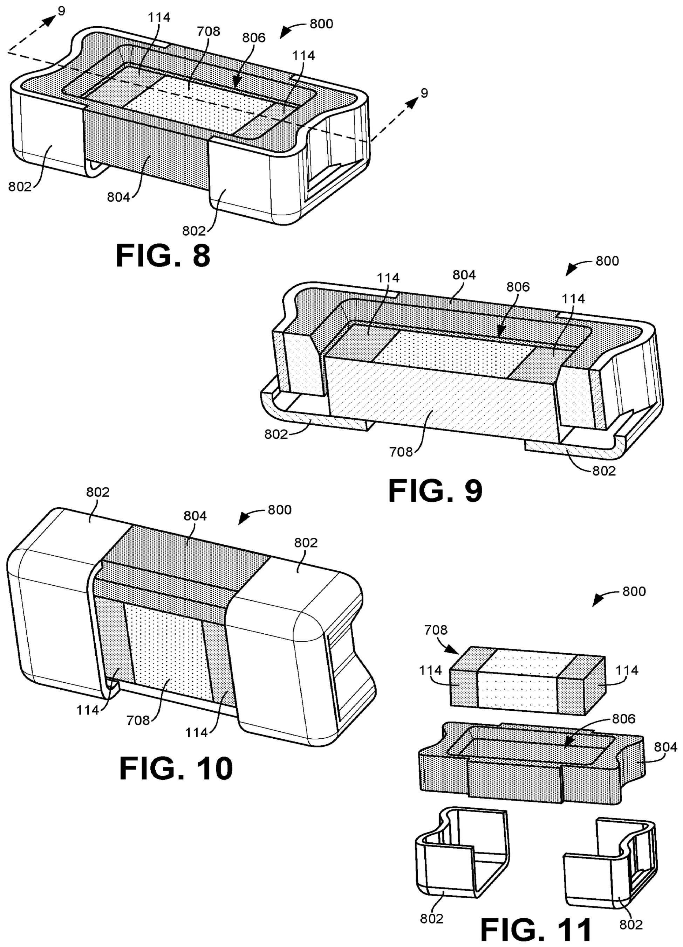

The third assembly 706 in FIG. 7 is created by inserting the smaller capacitor 708 into a shell or casing corresponding to the expander 710. Different example implementations of the third assembly 70 of FIG. 7 are detailed below in connection with FIGS. 8-15. More particularly, FIG. 8 is an isometric top view of an example assembly 800 that may be used to implement the third assembly 706 of FIG. 7. FIG. 9 is an isometric cutaway view of the example assembly 800 cut along the line 9-9 shown in FIG. 8. FIG. 10 is an isometric bottom view of the example assembly 800 of FIG. 8. FIG. 11 is an exploded view of the example assembly 800 of FIG. 8. As shown in the illustrated example of FIGS. 8-11, the assembly 800 includes an outer shell or cage 802 that defines the outer dimensions of the assembly 800. In some examples, the cage 802 has outer dimensions with a width and length that is the same as or similar to a larger capacitor (e.g., the larger capacitor 712 of FIG. 7). In some examples, only one of the length or the width of the outer dimensions of the cage 802 is similar to the larger capacitor 712 while the other dimension is different from the corresponding dimension of the larger capacitor 712. In this example, the cage 802 includes a conductive material (e.g., metal) to serve as an extension to the terminals 114 of a smaller capacitor 708 housed within the cage 802. Thus, in this example, the smaller capacitor 708 is electrically coupled to the cage 802 that constitutes an example means for conducting electricity. In some examples, the electrical coupling between the smaller capacitor 708 and the cage 802 is accomplished by the terminals 114 of the smaller capacitor 708 being in direct contact with the cage 802. In some examples, the electrical coupling between the smaller capacitor 708 and the cage 802 is accomplished by a solder material between the terminals 114 of the smaller capacitor 708 and the cage 802.

Notably, in the illustrated example, the cage 802 includes two separate parts that are electrically isolated from one another to ensure there is no short circuit between the two terminals 114 of the capacitor 708. More particularly, in some examples, the two parts of the cage 802 have a same or similar footprint to the terminals 114 of the larger capacitor 712. In some examples, the separate parts of the cage 802 are held in place relative to one another and relative to the capacitor 708 via an insert 804 (e.g., means for holding the cage 802 in position relative to the smaller capacitor 708) that fills gaps between inner walls of the cage 802 and the smaller capacitor 708. That is, as shown in the illustrated example, the insert 804 fits within the cage 802 and includes an opening 806 to receive the smaller capacitor 708. In some examples, the insert 804 includes a non-conductive material (e.g., a dielectric material) such as plastic. In some examples, the insert 804 is resiliently flexible to be press-fit into the cage 802 and/or to enable the smaller capacitor 708 to be press-fit into the opening 806 so the different components remain in fixed spatial relationship. Additionally or alternatively, in some examples, the cage 802 is formed of bent sheet metal that is resiliently flexible to clamp around the insert 804. Additionally or alternatively, in some examples, the insert 804 is affixed to the cage 802 and/or to the smaller capacitor 708 with an adhesive.

The exploded view of the example assembly 800 shown in FIG. 11 represents the process of combining the components of the assembly 800. As shown in the illustrated example, the smaller capacitor 708 is inserted into the cage 802 (and the insert 804) from the top. In some examples, the smaller capacitor 708 is first placed in the opening 806 in the insert 804 and then the insert 804 is inserted into the cage 802. In other examples, the insert 804 is first inserted into the cage 802 and then the smaller capacitor 708 is inserted into the opening 806 in the insert 804.

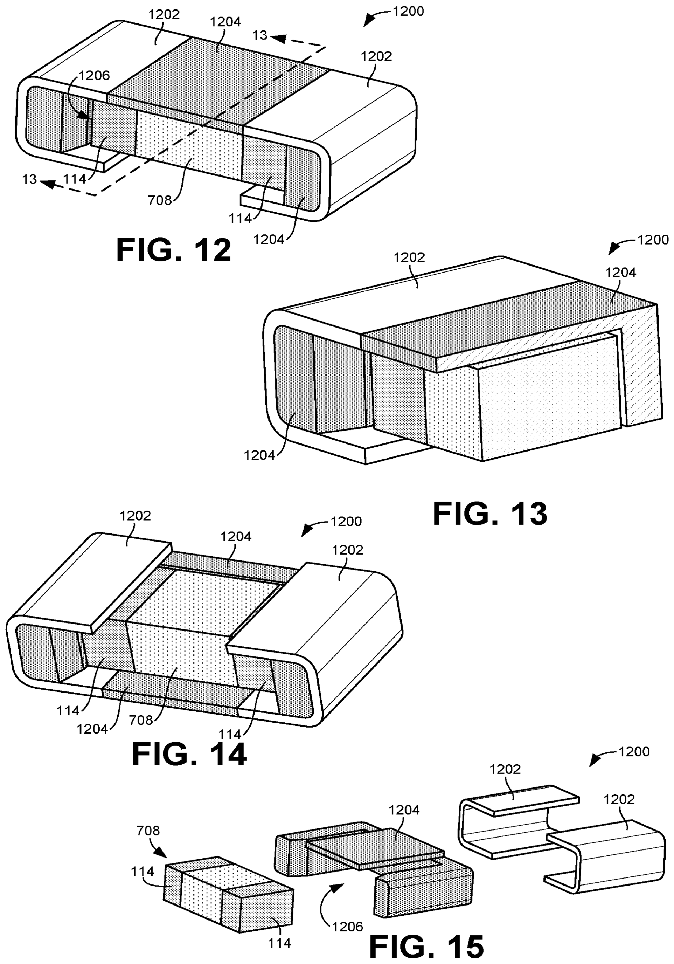

FIG. 12 is an isometric top view of another example assembly 1200 that may be used to implement the third assembly 706 of FIG. 7. FIG. 13 is an isometric cutaway view of the example assembly 1200 cut along the line 13-13 shown in FIG. 12. FIG. 14 is an isometric bottom view of the example assembly 1200 of FIG. 12. FIG. 15 is an exploded view of the example assembly 1200 of FIG. 12. As shown in the illustrated example of FIGS. 12-15, the assembly 1200 includes an out shell or cage 1202 that defines the outer dimensions of the assembly 1200. In some examples, the cage 1202 has outer dimensions with a width and length that is the same as or similar to a larger capacitor (e.g., the larger capacitor 712 of FIG. 7). In some examples, only one of the length or the width of the outer dimensions of the cage 1202 is similar to the larger capacitor 712 while the other dimension is different from the corresponding dimension of the larger capacitor 712. In this example, the cage 1202 includes a conductive material (e.g., metal) to serve as an extension to the terminals 114 of a smaller capacitor 708 housed within the cage 1202. Thus, in this example, the smaller capacitor 708 is electrically coupled to the cage 1202, which constitutes an example means for conducting electricity. In some examples, the electrical coupling between the smaller capacitor 708 and the cage 1202 is accomplished by the terminals 114 of the smaller capacitor 708 being in direct contact with the cage 1202. In some examples, the electrical coupling between the smaller capacitor 708 and the cage 1202 is accomplished by a solder material between the terminals 114 of the smaller capacitor 708 and the cage 1202.

As with FIGS. 8-11, in the illustrated example of FIGS. 12-15, the cage 1202 includes two separate parts that are electrically isolated from one another to ensure there is no short circuit between the two terminals 114 of the capacitor 708. More particularly, in some examples, the two parts of the cage 1202 have a same or similar footprint to the terminals 114 of the larger capacitor 712. In some examples, the separate parts of the cage 1202 are held in place relative to one another and relative to the capacitor 708 via an insert 1204 (e.g., means for holding the cage 802 in position relative to the smaller capacitor 708) that fills gaps between inner walls of the cage 1202 and the smaller capacitor 708. That is, as shown in the illustrated example, the insert 1204 fits within the cage 1202 and includes an opening 1206 to receive the smaller capacitor 708. In some examples, the insert 1204 includes a non-conductive material (e.g., a dielectric material) such as plastic. In some examples, the insert 1204 is resiliently flexible to be press-fit into the cage 1202 and/or to enable the smaller capacitor 708 to be press-fit into the opening 1206 so the different components remain in fixed spatial relationship. Additionally or alternatively, in some examples, the cage 1202 is formed of bent sheet metal that is resiliently flexible to clamp around the insert 1204. Additionally or alternatively, in some examples, the insert 1204 is affixed to the cage 1202 and/or to the smaller capacitor 708 with an adhesive.

The exploded view of the example assembly 1200 shown in FIG. 15 represents the process of combining the components of the assembly 1200. As shown in the illustrated example, the smaller capacitor 708 is inserted into the cage 1202 (and the insert 1204) from a lateral side of the assembly 800. In some examples, the smaller capacitor 708 is first placed in the opening 1206 in the insert 1204 and then the insert 1204 is inserted into the cage 1202. In other examples, the insert 1204 is first inserted into the cage 1202 and then the smaller capacitor 708 is inserted into the opening 1206 in the insert 1204.

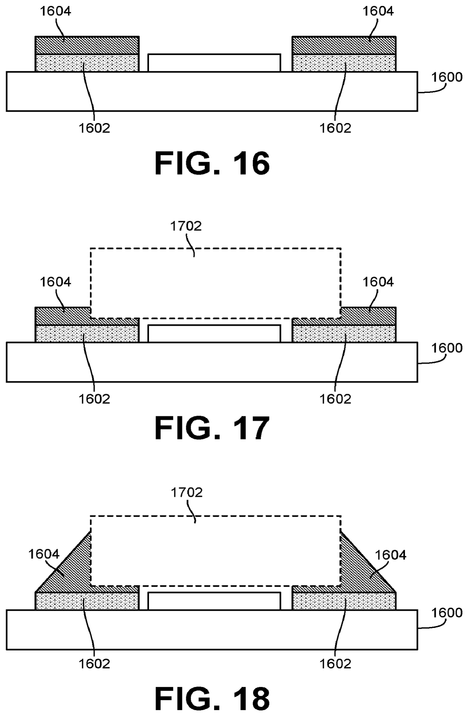

FIGS. 16-18 illustrates different stages in an example method to attach (e.g., surface mount) any of the example assemblies 510, 702, 704, 706, 800, 1200 of FIGS. 5-15 containing a smaller capacitor 708 onto a PCB 1600 with capacitor pads 1602 dimensioned for a larger capacitor 712. Specifically, FIG. 16 represents the stage after depositing a solder material 1604 onto the capacitor pads 1602. In some examples, the solder material 1604 is deposited as a paste through a printing process. In this example, the solder material 1604 is deposited across the entire exposed surfaces of the capacitor pads 1602. In other examples, the solder material 1604 is applied to only parts of the capacitor pads 1602 (e.g., in line with the examples of FIGS. 3 and/or 4). FIG. 17 represents the stage after placing a small capacitor assembly 1702 on to the solder material 1604 on both capacitor pads 1602. The small capacitor assembly 1702 is represented by a dashed box to generically represent any of the example assemblies 510, 702, 704, 706, 800, 1200 of FIGS. 5-15. In some examples, the small capacitor assembly 1702 is placed in position through a pick-and-place process. FIG. 18 represents the stage after a reflow process in which the solder material 1604 is melted and subsequently cooled to form the solder joints (with associated fillets) between the capacitor pads 1602 and the small capacitor assembly 1702.

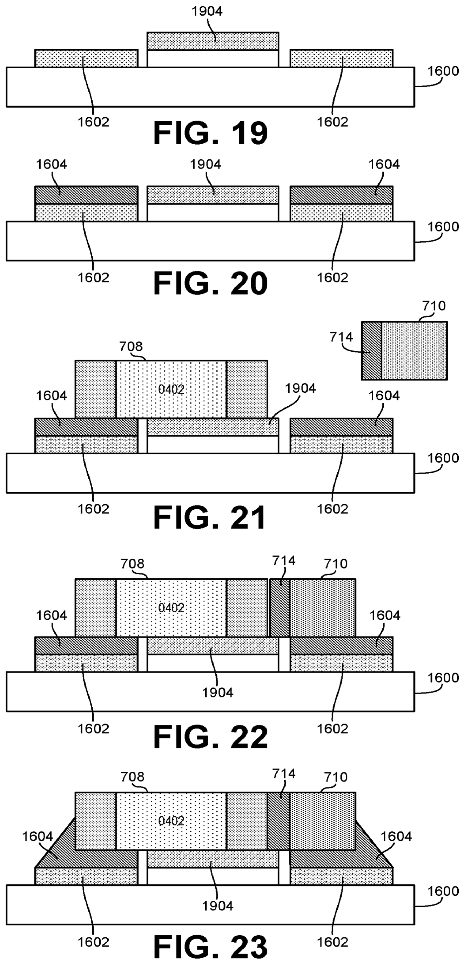

The example method detailed in connection with FIGS. 16-18 assumes that the small capacitor assembly 1702 is already assembled to be picked and placed in position in a single operation. In other examples, at least the first example assembly 702 of FIG. 7 can be assembled in place on the PCB 1600 as detailed in connection with FIGS. 19-23, which illustrate different stages in another example method to attach (e.g., surface mount) the first assembly 702 of FIG. 7. Specifically, FIG. 19 represents the stage after depositing a surface mount adhesive 1904 onto the PCB 1600. FIG. 20 represents the stage after depositing a solder material 1604 onto the capacitor pads 1602 (as discussed above in connection with FIG. 16).

FIG. 21 represents the stage after placing the smaller capacitor 708 on the solder material 1604 associated with one of the capacitor pads 1602. Further, as shown in the illustrated example, the smaller capacitor 708 is also placed on the surface mount adhesive 1904 positioned between the capacitor pads 1602. In some examples, the smaller capacitor 708 is placed in position through a pick-and-place process. The surface mount adhesive 1904 helps hold the smaller capacitor 708 in position during the subsequent processes to add the capacitor expander 710. That is, as shown in FIG. 21, the capacitor expander 710 is not yet attached to the smaller capacitor 708. However, in this example, the capacitor expander 710 includes the solder material 714 on the surface of the expander 710 that is to face towards the smaller capacitor 708. In some examples, the solder material 714 is applied to the smaller capacitor 708 in addition to or instead of being applied to the expander 710. In some examples, the expander 710 is placed on the PCB 1600 (e.g., on the surface mount adhesive 1904) first and the smaller capacitor 708 is positioned in a subsequent pick-and-place operation.

FIG. 22 represents the stage after placing the capacitor expander 710 adjacent to the smaller capacitor 708 with the solder material 714 therebetween. In some examples, the capacitor expander 710 is placed in position through a pick-and-place process. In some examples, the expander 710 (and/or the associated solder material 714) contacts the surface mount adhesive 1904. In other examples, the smaller capacitor 708 may entirely cover the surface mount adhesive 1904. FIG. 23 represents the stage after a reflow process in which the solder material 1604 on the capacitor pads 1602 and the solder material 714 between the smaller capacitor 708 and the expander 710 is melted and subsequently cooled to form the solder joints (with associated fillets) between the capacitor pads 1602 and the small capacitor assembly 1702 and between the smaller capacitor 708 and the expander 710 within the small capacitor assembly 702. Thus, in this example, only a single reflow process is needed rather than two.

As outlined above in connection with FIGS. 1-4, example capacitor pads 106, 108, 110, 200 with shapes having a heel 132 that is narrower than the toe 134 (e.g., the width 124 of the of the inner facing edges 120 of the capacitor pads 106, 108, 110, 200 is less than the width 126 of the outer facing edges 122) enable different sizes of capacitor to be reliably attached to the capacitor pads 106, 108, 110, 200. Further, as outlined above in connection with FIGS. 5-23, example capacitor expanders 508, 710 can be combined with smaller capacitors 104, 610, 708 to produce example capacitor assemblies 510, 702, 704, 706, 800, 1200 suitable to be attached to standard (e.g., rectangular) capacitor pads 502, 504, 506, 606, 1602 for a larger capacitor 102, 604, 712. In some examples, aspects and/or features of FIGS. 1-4 can be used in combination with aspects and/or features of FIGS. 5-23. That is, in some examples, a small capacitor is coupled to an example capacitor expander 508, 710 to adjust an effective size of the capacitor for purposes of surface mounting and the resulting assembly is then mounted to capacitor pads having any of the example shapes described in connection with FIGS. 1 and 2. Further, in any of the foregoing examples, solder material can be applied to an entire area of the capacitor pads or only selective areas (as discussed in connection with FIGS. 3 and 4) to facilitate the attachment of the capacitors (and/or capacitor assemblies) to the capacitor pads. In other words, although different figures show different examples with different features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features.

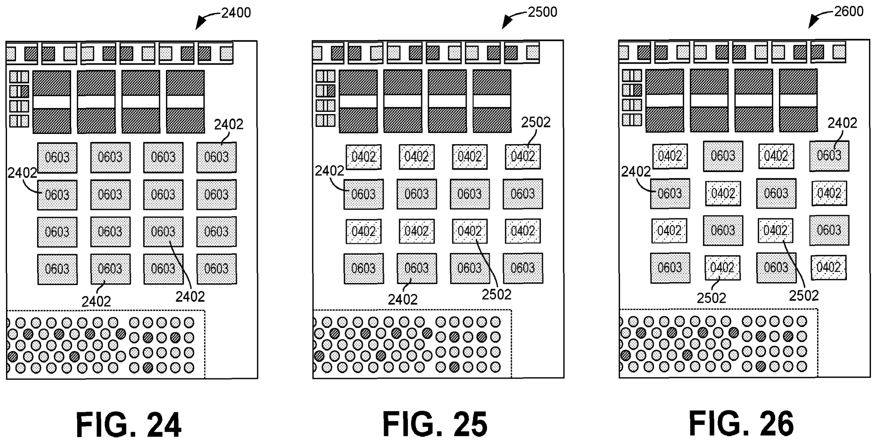

The ability to attach or mount different sizes of capacitors to the same size of capacitor pads (whether due to the shape of the pads and/or due to a capacitor expander attached to a smaller capacitor) is advantageous because it can significantly facilitate making trade-offs between improved performance at lower cost (based on larger capacitors) and reduced noise (based on smaller capacitors) without the time or expense of a complete redesign of the PCB layout. More particularly, PCB design engineers can design and build a PCB beginning with the assumption that the larger capacitors will be used. FIG. 24 is a top view of an example PCB assembly 2400 constructed in this manner with an array of large capacitors 2402 (e.g., 0603 capacitors). Once the PCB assembly is designed, the engineers can test the assembly to verify the resulting acoustic noise. If the level of noise exceeds acceptable thresholds, the engineers can swap out one or more of the larger capacitors with one or more smaller capacitors until a suitable design is arrived at that satisfies noise level requirements while still meeting electrical capacitance requirements. Inasmuch as smaller capacitors can be reliably attached to the capacitor pads in accordance with teachings disclosed herein, the engineers do not need to redesign the underlying PCB. Furthermore, the engineers can select any suitable number of the larger capacitors to swap out in any suitable arrangement. FIGS. 25 and 26 illustrate two possible arrangements of small and large capacitors corresponding to the PCB assembly 2400 of FIG. 24. Specifically, FIG. 25 illustrates an example PCB assembly 2500 similar to that shown in FIG. 24 except that individual rows of the large capacitors 2402 of FIG. 24 have been replaced with corresponding rows of smaller capacitors 2502. FIG. 26 illustrates an example PCB assembly 2600 similar to that shown in FIG. 25 except that the larger and smaller capacitors 2402, 2502 are arranged in a checkerboard pattern. Any other suitable arrangement is possible.

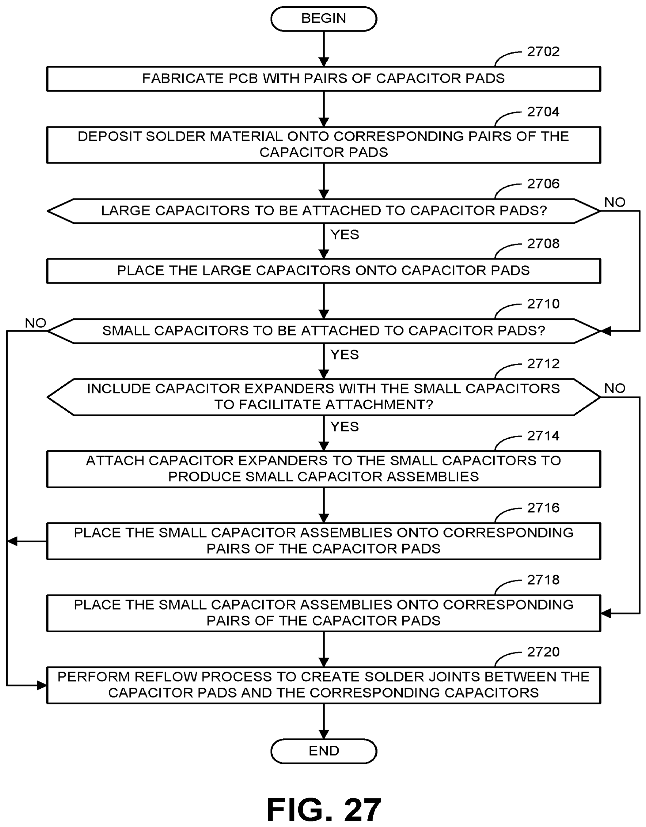

FIG. 27 is a flowchart representative of an example method of manufacturing any one of the example PCB assemblies 2400, 2500, 2600 of FIGS. 24-26 using any of the example capacitor pads 106, 108, 110, 200, 502, 504, 506, 606, 1602 of FIGS. 1-23 and/or any of the example capacitor expanders 508, 710 of FIGS. 5-23. In some examples, some or all of the operations outlined in the example method of FIG. 27 are performed automatically by fabrication equipment that is programmed to perform the operations. Although the example method of manufacturing is described with reference to the flowchart illustrated in FIG. 27, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method of FIG. 27 begins at block 2702 by fabricating a PCB with pairs of capacitor pads. In some examples, the capacitor pads can be standard (known) pads dimensioned for a larger capacitor. In some examples, the capacitor pads can have inner facing edges 120 that are smaller (narrower) than the outer facing edges 122 as discussed above in connection with FIGS. 1 and 2. At block 2704, the example method involves depositing solder material onto corresponding pairs of the capacitor pads. In some examples, the solder material is deposited across the entire exposed surface of the capacitor pads. In other examples, the solder material is deposited over regions corresponding to less than the entire exposed surface of the capacitor pads. More particularly, in some examples, the region(s) covered by the solder material depends on whether a larger capacitor or a smaller capacitor is to be attached to the corresponding pair of capacitor pads.

At block 2706, the example method involves determining whether large capacitors are to be attached to the capacitor pads. If so, the example method advances to block 2708, which involves placing the large capacitors onto the capacitor pads. Thereafter, the example method advances to block 2710. If no large capacitors are to be attached (as determined at block 2706), the example method advances directly to block 2710.

At block 2710, the example method involves determining whether small capacitors are to be attached to the capacitor pads. If so, the example method advances to block 2712, which involves determining whether to include capacitor expanders with the small capacitors to facilitate attachment. In some examples, capacitor expanders are included when the capacitor pads have a standard (e.g., rectangular) shape. In some examples, when the capacitor pads include shapes as described above in connection with FIGS. 1 and 2, there is no need for capacitor expanders. However, in some examples, capacitor expanders may be used in combination with capacitor pads shaped as described above in connection with FIGS. 1 and 2. If capacitor expanders are to be included, the example method advances to block 2714.

At block 2714, the example method involves attaching capacitor expanders to the small capacitors to produce small capacitor assemblies. In some examples, the small capacitor assemblies corresponding to any of the example assemblies discussed above in connection with FIGS. 5-23. Thereafter, at block 2716, the example method involves placing the small capacitor assemblies onto corresponding pairs of the capacitor pads. In some examples, the implementation of block 2714 and 2716 is modified such that the small capacitor assemblies are formed in place on the capacitor pads. That is, in some examples, either the small capacitors or the expanders are first placed on the capacitor pads and then the other component is placed next to the first. Regardless of the order of operations, once the full capacitor assemblies have been placed on the corresponding capacitor pads, the example method advances to block 2720.

Returning to block 2712, if capacitor expanders are not to be included, the example method advances to block 2718, which involves placing the small capacitors onto the capacitor pads. Thereafter, the example method advances to block 2720. Returning to block, 2710, if no small capacitors are to be attached, the example method advances directly to block 2720. At block 2720, the example method involves performing a reflow process to create solder joints between the capacitor pads and the corresponding capacitors. Thereafter, the example method of FIG. 27 ends.

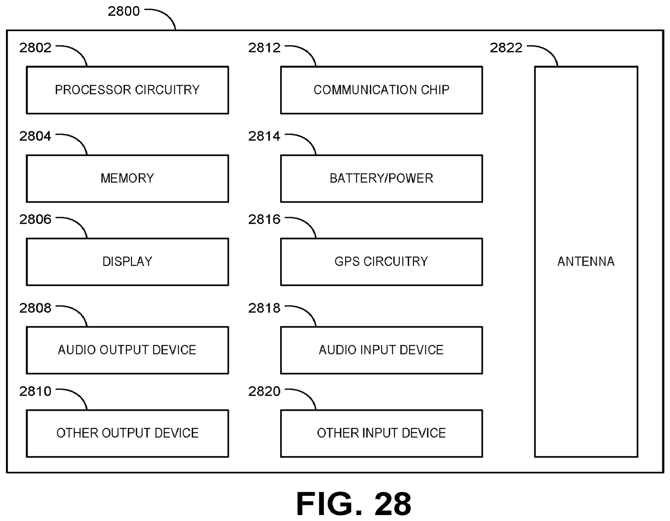

FIG. 28 is a block diagram of an example electrical device 2800 that may include one or more of the example PCB assemblies 2400, 2500, 2600 of FIGS. 24-26 using any of the example capacitor pads 106, 108, 110, 200, 502, 504, 506, 606, 1602 of FIGS. 1-23 and/or any of the example capacitor expanders 508, 710 of FIGS. 5-23. A number of components are illustrated in FIG. 28 as included in the electrical device 2800, but any one or more of these components may be omitted or duplicated, as suitable for the application. In some examples, some or all of the components included in the electrical device 2800 may be attached to one or more motherboards. In some examples, some or all of these components are fabricated onto a single system-on-a-chip (SoC) die.

Additionally, in various examples, the electrical device 2800 may not include one or more of the components illustrated in FIG. 28, but the electrical device 2800 may include interface circuitry for coupling to the one or more components. For example, the electrical device 2800 may not include a display 2806, but may include display interface circuitry (e.g., a connector and driver circuitry) to which a display 2806 may be coupled. In another set of examples, the electrical device 2800 may not include an audio input device 2818 (e.g., microphone) or an audio output device 2808 (e.g., a speaker, a headset, earbuds, etc.), but may include audio input or output device interface circuitry (e.g., connectors and supporting circuitry) to which an audio input device 2818 or audio output device 2808 may be coupled.

The electrical device 2800 may include programmable circuitry 2802 (e.g., one or more processing devices). The programmable circuitry 2802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 2800 may include a memory 2804, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 2804 may include memory that shares a die with the programmable circuitry 2802. This memory may be used as cache memory and may include embedded dynamic random access memory (eDRAM) or spin transfer torque magnetic random access memory (STT-MRAM).

In some examples, the electrical device 2800 may include a communication chip 2812 (e.g., one or more communication chips). For example, the communication chip 2812 may be configured for managing wireless communications for the transfer of data to and from the electrical device 2800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 2812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2812 may operate in accordance with other wireless protocols in other examples. The electrical device 2800 may include an antenna 2822 to facilitate wireless communications and/or to receive other wireless communications (such as AM or FM radio transmissions).

In some examples, the communication chip 2812 may manage wired communications, such as electrical, optical, or any other suitable communication protocols (e.g., the Ethernet). As noted above, the communication chip 2812 may include multiple communication chips. For instance, a first communication chip 2812 may be dedicated to shorter-range wireless communications such as Wi-Fi or Bluetooth, and a second communication chip 2812 may be dedicated to longer-range wireless communications such as global positioning system (GPS), EDGE, GPRS, CDMA, WiMAX, LTE, EV-DO, or others. In some examples, a first communication chip 2812 may be dedicated to wireless communications, and a second communication chip 2812 may be dedicated to wired communications.

The electrical device 2800 may include battery/power circuitry 2814. The battery/power circuitry 2814 may include one or more energy storage devices (e.g., batteries or capacitors) and/or circuitry for coupling components of the electrical device 2800 to an energy source separate from the electrical device 2800 (e.g., AC line power).

The electrical device 2800 may include a display 2806 (or corresponding interface circuitry, as discussed above). The display 2806 may include any visual indicators, such as a heads-up display, a computer monitor, a projector, a touchscreen display, a liquid crystal display (LCD), a light-emitting diode display, or a flat panel display.

The electrical device 2800 may include an audio output device 2808 (or corresponding interface circuitry, as discussed above). The audio output device 2808 may include any device that generates an audible indicator, such as speakers, headsets, or earbuds.

The electrical device 2800 may include an audio input device 2818 (or corresponding interface circuitry, as discussed above). The audio input device 2818 may include any device that generates a signal representative of a sound, such as microphones, microphone arrays, or digital instruments (e.g., instruments having a musical instrument digital interface (MIDI) output).

The electrical device 2800 may include GPS circuitry 2816. The GPS circuitry 2816 may be in communication with a satellite-based system and may receive a location of the electrical device 2800, as known in the art.

The electrical device 2800 may include any other output device 2810 (or corresponding interface circuitry, as discussed above). Examples of the other output device 2810 may include an audio codec, a video codec, a printer, a wired or wireless transmitter for providing information to other devices, or an additional storage device.

The electrical device 2800 may include any other input device 2820 (or corresponding interface circuitry, as discussed above). Examples of the other input device 2820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 2800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 2800 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable different sizes of (SMT) components (e.g., capacitors) to be attached to the same footprint of SMT contact pads. In some examples, this advantage is achieved through contact pad designs that are compatible with the different sizes of SMT components based on the pads having larger (wider) portions near the toes of the pads (e.g., adjacent the outer facing edges of corresponding pairs of pads) and having smaller (narrower) portions near the heels of the pads (e.g., adjacent the inner facing edges of corresponding pairs of pads). Additionally or alternatively, in some examples, a component expander is provided in connection with a smaller SMT component to produce an assembly having a size that is comparable to a larger SMT component, thereby enabling the assembly to be attached to contact pads dimensioned for the larger size SMT component. As a result of teachings disclosed herein, different sizes of SMT component can be swapped or interchanged for one another on a given PCB (and/or different arranged on two similar PCBs) without the need to redesign and/or rebuild a new PCB with a different layout (and different associated pads). As such, it is much easier for PCB assemblies to be designed with suitable trade-offs between performance and acoustic noise.

Further examples and combinations thereof include the following:
Example 1 includes an apparatus comprising a circuit board, a first pad on the circuit board, the first pad to be electrically coupled to a first terminal of a surface mounting technology (SMT) component, the first pad having a first edge and a second edge opposite the first edge, the first edge shorter than the second edge, and a second pad on the circuit board, the second pad to be electrically coupled to a second terminal of the SMT component, the second pad having a third edge and a fourth edge opposite the third edge, the third edge shorter than the fourth edge.
Example 2 includes any preceding clause(s) of example 1, wherein the first and third edges face towards one another and the second and fourth edges face away from one another.
Example 3 includes any preceding clause(s) of any one or more of examples 1-2, wherein the first edge has a same length as the third edge, and the second edge has a same length as the fourth edge.
Example 4 includes any preceding clause(s) of any one or more of examples 1-3, wherein the first pad includes a side edge extending between the first edge and the second edge, the side edge following a non-linear line.
Example 5 includes any preceding clause(s) of any one or more of examples 1-4, wherein the side edge includes a tapered edge that extends at a non-perpendicular angle relative to the first and second edges.
Example 6 includes any preceding clause(s) of any one or more of examples 1-5, wherein the side edge includes a stepped profile.
Example 7 includes any preceding clause(s) of any one or more of examples 1-6, wherein the first pad includes a first portion and a second portion, the first portion defined by the first edge and opposing first side edges, the second portion defined by the second edge and opposing second side edges.
Example 8 includes any preceding clause(s) of any one or more of examples 1-7, wherein the first and second portions are spaced apart from one another with a gap therebetween.
Example 9 includes any preceding clause(s) of any one or more of examples 1-8, wherein the first portion is a continuous extension of the second portion.
Example 10 includes any preceding clause(s) of any one or more of examples 1-9, wherein the first portion has a first length extending in a direction transverse to the first and second edges, and the second portion has a second length extending in a direction transverse to the first and second edges, the first length greater than the second length.
Example 11 includes any preceding clause(s) of any one or more of examples 1-10, wherein the first portion has a first length extending in a direction transverse to the first and second edges, and the second portion has a second length extending in a direction transverse to the first and second edges, the second length greater than the first length.
Example 12 includes any preceding clause(s) of any one or more of examples 1-11, wherein the SMT component is one of a first SMT component or a second SMT component, the first SMT component having a first footprint, and the second SMT component having a second footprint, the first footprint larger than the second footprint.
Example 13 includes any preceding clause(s) of any one or more of examples 1-12, wherein the first footprint has a first width and the second footprint has a second width smaller than the first width, the first edge greater than the first width and less than or equal to the second width.
Example 14 includes any preceding clause(s) of any one or more of examples 1-13, wherein the first footprint has a first length and the second footprint has a second length smaller than the first length, the first and third edges a first distance apart, the second and fourth edges a second distance apart, the first distance less than the second length, the second distance less than the first length.
Example 15 includes any preceding clause(s) of any one or more of examples 1-14, wherein the SMT component is a multilayer ceramic capacitor.
Example 16 includes an apparatus comprising a circuit board including a first pair of capacitor pads and a second pair of capacitor pads, the first pair of capacitor pads having a same size and a same shape as the second pair of capacitor pads, a first capacitor electrically coupled to the first pair of capacitor pads, and a second capacitor electrically coupled to the second pair of capacitor pads, the second capacitor smaller than the first capacitor.
Example 17 includes any preceding clause(s) of example 16, wherein the first pair of capacitor pads includes a first pad and a second pad, the first pad including a first portion and a second portion, the first portion defined by an inner facing edge and opposing first side edges, the second portion defined by an outer facing edge and opposing second side edges, the inner facing edge facing towards the second pad, the outer facing edge facing in an opposite direction to the inner facing edge.
Example 18 includes any preceding clause(s) of any one or more of examples 16-17, wherein the inner facing edge is smaller than the outer facing edge.
Example 19 includes any preceding clause(s) of any one or more of examples 16-18, wherein the first side edges are substantially parallel.
Example 20 includes any preceding clause(s) of any one or more of examples 16-19, wherein the first side edges angle outward from the inner facing edge.
Example 21 includes any preceding clause(s) of any one or more of examples 16-20, wherein the first pad includes inward facing recessed edges that extend between respective ones of the first side edges and corresponding ones of the second side edges.
Example 22 includes any preceding clause(s) of any one or more of examples 16-21, wherein the first and second portions are spaced apart from one another with a gap therebetween.
Example 23 includes any preceding clause(s) of any one or more of examples 16-22, wherein the first portion is a continuous extension of the second portion.
Example 24 includes any preceding clause(s) of any one or more of examples 16-23, wherein the first portion has a first length extending in a first direction transverse to the inner and outer facing edges, and the second portion has a second length extending in the first direction, the first length greater than the second length.
Example 25 includes any preceding clause(s) of any one or more of examples 16-24, wherein the first portion has a first length extending in a first direction transverse to the inner and outer facing edges, and the second portion has a second length extending in the first direction, the second length greater than the first length.
Example 26 includes any preceding clause(s) of any one or more of examples 16-25, wherein the inner facing edge is a first inner facing edge, the outer facing edge is a second outer facing edge, and the second pair of capacitor pads includes a third pad and a fourth pad, the third pad including a second inner facing edge and a second outer facing edge, the apparatus including first solder on the first pad and second solder on the third pad, the first solder spaced apart from the first inner facing edge, the second solder spaced apart from the second outer facing edge.
Example 27 includes any preceding clause(s) of any one or more of examples 16-26, wherein the first capacitor is a 0603 capacitor, and the second capacitor is a 0402 capacitor.
Example 28 includes any preceding clause(s) of any one or more of examples 16-27, including a capacitor expander coupled to the second capacitor, the second capacitor and the capacitor expander collectively having dimensions corresponding to at least one of a length or a width of the first capacitor.
Example 29 includes an apparatus comprising means for supporting electronic components, and means for mounting the electronic components on the supporting means, the mounting means including (i) first means for attaching a first component of a first size and (ii) second means for attaching a second component of a second size, the first size greater than the second size.
Example 30 includes any preceding clause(s) of example 29, wherein the first attaching means is larger than the second attaching means.
Example 31 includes any preceding clause(s) of any one or more of examples 29-30, including first and second ones of the mounting means adjacent one another to enable attachment of separate terminals of one of the first component or the second component, the first and second attaching means of both the first and second ones of the mounting means in a line.
Example 32 includes any preceding clause(s) of any one or more of examples 29-31, wherein the second attaching means of both the first and second ones of the mounting means are between the first attaching means of both the first and second ones of the mounting means along the line.
Example 33 includes any preceding clause(s) of any one or more of examples 29-32, wherein the first attaching means has a first width measured in a direction perpendicular to the line, and the second attaching means has a second width measured in the direction perpendicular to the line, the second width less than the first width.
Example 34 includes any preceding clause(s) of any one or more of examples 29-33, wherein the second width is less than or equal to a width of the second component.
Example 35 includes any preceding clause(s) of any one or more of examples 29-34, where the second attaching means is spaced apart from the first attaching means.
Example 36 includes any preceding clause(s) of any one or more of examples 29-35, wherein the second attaching means is an integral extension of the first attaching means.
Example 37 includes a method comprising fabricating a circuit board with a pair of capacitor pads, the capacitor pads having inner edges facing towards one another and outer edges facing away from one another, the inner edges shorter than the outer edges, and depositing solder on the capacitor pads.
Example 38 includes any preceding clause(s) of example 37, wherein the depositing of the solder includes depositing the solder on regions smaller than entire areas of the capacitor pads.
Example 39 includes any preceding clause(s) of any one or more of examples 37-38, attaching one of a first capacitor or a second capacitor to the capacitor pads, the first capacitor larger than the second capacitor, the regions adjacent to the outer edges when the first capacitor is to be attached, the regions adjacent to the inner edges when the first capacitor is to be attached.
Example 40 includes an apparatus comprising a first surface mounting technology (SMT) component having a first width and a first length, and a dummy structure coupled to the first SMT component, the dummy structure to enable terminals of the first SMT to be electrically coupled to contact pads, the contact pads having a size to mount a second SMT component that is larger than the first SMT component.
Example 41 includes any preceding clause(s) of example 40, wherein the first SMT component has a first width and a first length, and the second SMT component has a second width and a second length, the second width greater than the first width, the second length greater than the second length.
Example 42 includes any preceding clause(s) of any one or more of examples 40-41, wherein a combined length of the first SMT component and the dummy structure approximately equals the second length.
Example 43 includes any preceding clause(s) of any one or more of examples 40-42, wherein a combined width of the first SMT component and the dummy structure approximately equals the second width.
Example 44 includes any preceding clause(s) of any one or more of examples 40-43, wherein a combined length of the first SMT component and the dummy structure approximately equals the second length, and a combined width of the first SMT component and the dummy structure approximately equals the second width.
Example 45 includes any preceding clause(s) of any one or more of examples 40-44, wherein the dummy structure is coupled to the first SMT component via solder between the dummy structure and the first SMT component.
Example 46 includes any preceding clause(s) of any one or more of examples 40-45, wherein the dummy structure is an electrically conductive block.
Example 47 includes any preceding clause(s) of any one or more of examples 40-46, wherein the dummy structure is in direct contact with at least one of the terminals of the first SMT component.
Example 48 includes any preceding clause(s) of any one or more of examples 40-47, wherein the dummy structure is held in direct contact with the at least one of the terminals of the first SMT component by a plate extending along sides of the dummy structure and the first SMT component.
Example 49 includes any preceding clause(s) of any one or more of examples 40-48, wherein the dummy structure includes an electrically conductive cage, the first SMT component inside the cage.
Example 50 includes any preceding clause(s) of any one or more of examples 40-49, wherein the cage includes a first part and a second part spaced apart from the first part, the first part electrically coupled to a first terminal of the first SMT component, the second part electrically coupled to a second terminal of the first SMT component.
Example 51 includes any preceding clause(s) of any one or more of examples 40-50, wherein the dummy structure includes a non-conductive insert between the first and second parts of the cage, the first SMT component in an opening in the insert.
Example 52 includes any preceding clause(s) of any one or more of examples 40-51, wherein the first SMT component is to be inserted into the cage through a side of the cage, the side extending between a top and bottom of the cage, the bottom to face towards the contact pads, the top to face away from the contact pads.
Example 53 includes any preceding clause(s) of any one or more of examples 40-52, wherein the first SMT component is to be inserted into the cage through a top of the cage, the top to face away from the contact pads.
Example 54 includes a method comprising coupling a capacitor expander to a capacitor to provide an assembly with a larger dimension than the capacitor, and mounting the assembly to a pair of capacitor pads on a circuit board.
Example 55 includes any preceding clause(s) of example 54, wherein the coupling of the capacitor expander to the capacitor includes soldering the capacitor expander to the capacitor.
Example 56 includes any preceding clause(s) of any one or more of examples 54-55, wherein the soldering occurs after the capacitor is attached to the circuit board.
Example 57 includes any preceding clause(s) of any one or more of examples 54-56, including providing an adhesive between the pair of capacitor pads, the adhesive to hold the capacitor in place prior to the soldering.
Example 58 includes any preceding clause(s) of any one or more of examples 54-57, wherein the soldering occurs before the capacitor is attached to the circuit board.
Example 59 includes any preceding clause(s) of any one or more of examples 54-58, wherein the coupling of the capacitor expander to the capacitor includes attaching a plate to sides of the capacitor expander and the capacitor, the plate to hold the capacitor expander adjacent to the capacitor.
Example 60 includes any preceding clause(s) of any one or more of examples 54-59, wherein capacitor expander includes a conductive cage and a non-conductive insert, and the coupling of the capacitor expander to the capacitor includes inserting the capacitor into an opening in the insert, and inserting the insert into the cage.
Example 61 includes any preceding clause(s) of any one or more of examples 54-60, wherein the opening in the insert is accessible via a top of the assembly, the top of the assembly to face away from the capacitor pads.
Example 62 includes any preceding clause(s) of any one or more of examples 54-61, wherein the opening in the insert is accessible via a side of the assembly, the side extending between a top and bottom of the assembly, the bottom to face towards the capacitor pads, the top to face away from the capacitor pads.
Example 63 includes an apparatus comprising means for supporting electronic components, the supporting means including means for mounting the electronic components on the supporting means; an electronic component electrically coupled to the supporting means via a pair of the mounting means; and means for facilitating the electronic component to span a distance between the pair of the mounting means, the facilitating means electrically coupled between the electronic component and at least one of the mounting means in the pair.
Example 64 includes any preceding clause(s) of example 63, wherein the facilitating means includes a means for conducting electricity and means for holding the conducting means in position relative to the electronic component.
Example 65 includes any preceding clause(s) of any one or more of examples 63-64, wherein the holding means is electrically conductive.
Example 66 includes any preceding clause(s) of any one or more of examples 63-65, wherein the holding means is not electrically conductive.
Example 67 includes any preceding clause(s) of any one or more of examples 63-66, wherein the holding means is between the electronic component and the conducting means.
Example 68 includes any preceding clause(s) of any one or more of examples 63-67, wherein the conducting means is in direct contact with the electronic component, and the holding means extends along sides of the conducting means and the electronic component.
Example 69 includes any preceding clause(s) of any one or more of examples 63-68, wherein the electronic component is inserted into an opening in the holding means, and the holding means is contained within the conducting means.
Example 70 includes any preceding clause(s) of any one or more of examples 63-69, wherein the facilitating means is attached to a first end of the electronic component and spaced apart from a second end of the electronic component.
Example 71 includes any preceding clause(s) of any one or more of examples 63-70, wherein the facilitating means surrounds the electronic component.
Example 72 includes any preceding clause(s) of any one or more of examples 63-71, wherein the apparatus is a computing device including memory and programmable circuitry.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a circuit board;
a first pad on the circuit board, the first pad to be electrically coupled to a first terminal of a surface mounting technology (SMT) component, the first pad having a first edge and a second edge opposite the first edge, the first edge shorter than the second edge; and
a second pad on the circuit board, the second pad to be electrically coupled to a second terminal of the SMT component, the second pad having a third edge and a fourth edge opposite the third edge, the third edge shorter than the fourth edge.

2. The apparatus of claim 1, wherein the first and third edges face towards one another and the second and fourth edges face away from one another.

3. The apparatus of any one of claims 1-2, wherein the first edge has a same length as the third edge, and the second edge has a same length as the fourth edge.

4. The apparatus of any one of claims 1-3, wherein the first pad includes a side edge extending between the first edge and the second edge, the side edge following a non-linear line.

5. The apparatus of claim 4, wherein the side edge includes a tapered edge that extends at a non-perpendicular angle relative to the first and second edges.

6. The apparatus of any one of claims 4-5, wherein the side edge includes a stepped profile.

7. The apparatus of any one of claims 1-6, wherein the first pad includes a first portion and a second portion, the first portion defined by the first edge and opposing first side edges, the second portion defined by the second edge and opposing second side edges.

8. The apparatus of claim 7, wherein the first and second portions are spaced apart from one another with a gap therebetween.

9. The apparatus of claim 7, wherein the first portion is a continuous extension of the second portion.

10. The apparatus of any one of claims 7-9, wherein the first portion has a first length extending in a direction transverse to the first and second edges, and the second portion has a second length extending in a direction transverse to the first and second edges, the first length greater than the second length.

11. The apparatus of any one of claims 7-9, wherein the first portion has a first length extending in a direction transverse to the first and second edges, and the second portion has a second length extending in a direction transverse to the first and second edges, the second length greater than the first length.

12. The apparatus of any one of claims 1-11, wherein the SMT component is one of a first SMT component or a second SMT component, the first SMT component having a first footprint, and the second SMT component having a second footprint, the first footprint larger than the second footprint.

13. The apparatus of claim 12, wherein the first footprint has a first width and the second footprint has a second width smaller than the first width, the first edge greater than the first width and less than or equal to the second width.

14. The apparatus of any one of claims 12-13, wherein the first footprint has a first length and the second footprint has a second length smaller than the first length, the first and third edges a first distance apart, the second and fourth edges a second distance apart, the first distance less than the second length, the second distance less than the first length.

15. The apparatus of any one of claims 12-14, wherein the SMT component is a multilayer ceramic capacitor.
